(19) Europäisches Patentamt

European Patent Office

Office européen des brevets

(11) Veröffentlichungsnummer: **0 349 557 B1**

(12) **EUROPÄISCHE PATENTSCHRIFT**

(45) Veröffentlichungstag der Patentschrift:
09.10.91 Patentblatt 91/41

(51) Int. Cl.$^5$: **H03K 19/096**

(21) Anmeldenummer: 88902397.4

(22) Anmeldetag: 15.03.88

(86) Internationale Anmeldenummer:
PCT/DE88/00158

(87) Internationale Veröffentlichungsnummer:
WO 88/07292 22.09.88 Gazette 88/21

(54) GATTERSCHALTUNG MIT MOS-TRANSISTOREN.

(30) Priorität: 16.03.87 DE 3708534
24.02.88 DE 3805798

(43) Veröffentlichungstag der Anmeldung:
10.01.90 Patentblatt 90/02

(45) Bekanntmachung des Hinweises auf die
Patenterteilung:
09.10.91 Patentblatt 91/41

(84) Benannte Vertragsstaaten:
AT DE FR GB IT NL

(56) Entgegenhaltungen:
US-A- 4 595 845
Electronics International, Bamd 56, Nr. 19,
September 1983, (New York, US), S.Whitaker:
"Pass-transistor networks optimize n-MOS logic", Seiten 144-148

(56) Entgegenhaltungen:
Patent Abstracts of Japan, Band 8, Nr. 149
(E-255)(1586), 12. Juli 1984 & JP A 5954331
IBM Technical Disclosure Bulletin, Band 23,
Nr. 10, März 1981, (New York, US), W.R. Kraft et
al.: "Zero power and gate", Seite 4394
Patent Abstracts of Japan, Band 9, Nr. 75
(E-306)(1798), 4 April 1985 & JP A 59208943

(73) Patentinhaber: SIEMENS
AKTIENGESELLSCHAFT
Wittelsbacherplatz 2
W-8000 München 2 (DE)

(72) Erfinder: HOFFMANN, Kurt
Nelkenweg 20
W-8028 Taufkirchen (DE)
Erfinder: KOWARIK, Oscar
Goethering 70
W-8018 Grafing (DE)
Erfinder: KRAUS, Reiner
Weidener Str. 21
W-8000 München 83 (DE)

**Beschreibung**

Die vorliegende Erfindung betrifft eine Gatterschaltung mit MOS-Transistoren.

Aus der Bipolartechnologie sind sogenannte Open-Collector-Gatterschaltungen bekannt. Sie zeichnen sich gegenüben den sonstigen üblichen Gatterschaltungen aus durch unkomplizierten elektrischen Aufbau, problemlose Ausgestaltungsmöglichkeiten sowie hohen Fan-Out (Maß dafür, wie viele Eingänge anderer Bausteine an einen Ausgang anschließbar sind).

Auf dem Gebiet den MOS-Technologie ist bis heute keine entsprechend einfache Gatterschaltung bekannt. Aus IBM Technical Disclosure Bulletin, Vol. 23, No. 10, March 1981, Seiten 4394, 4395 ist eine Anordnung zum Schalten von Datensignalen im Multiplexbetrieb bekannt. Das Schalten von Datensignalen wird für jedes Datensignal individuell gesteuert.

Weiterhin sind aus Electronics International, Vol. 56, Sept. 1983, No. 19, Seiten 144 bis 148, "Pass-Transistor"-Netzwerke bekannt zur Durchführung von Transferlogik-Funktionen. Dabei werden ebenfalls Eingangs-Datensignale durch individuelle Steuersignale gesteuert.

Aufgabe der vorliegenden Erfindung ist es, eine gattungsgemäße Schaltung zu schaffen, die integrierbar ist, einen möglichst einfachen Aufbau aufweist und möglichst vielseitig einsetzbar ist.

Diese Aufgabe wird bei einer gattungsgemäßen Schaltung gelöst durch die kennzeichnenden Merkmale des Patentanspruches 1. Vorteilhafte Aus- und Weiterbildungen sind in Unteransprüchen gekennzeichnet.

Die Erfindung wird im folgenden anhand der FIG näher erläutert.

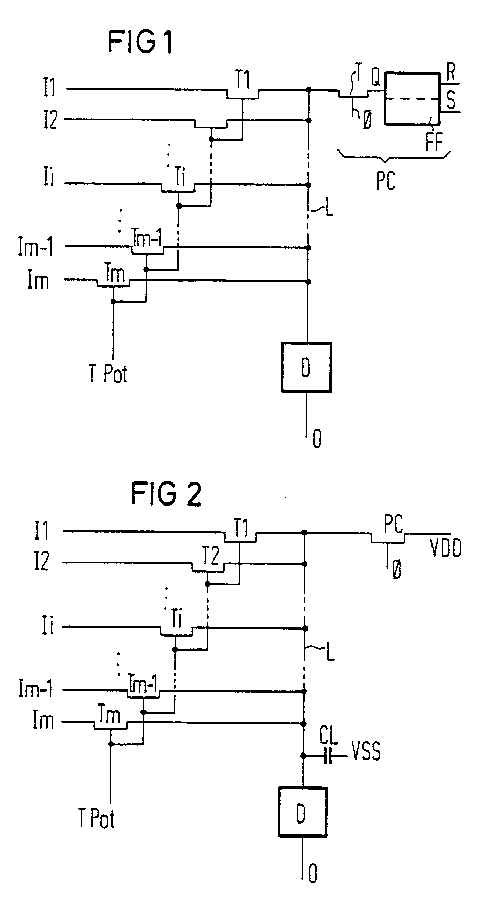

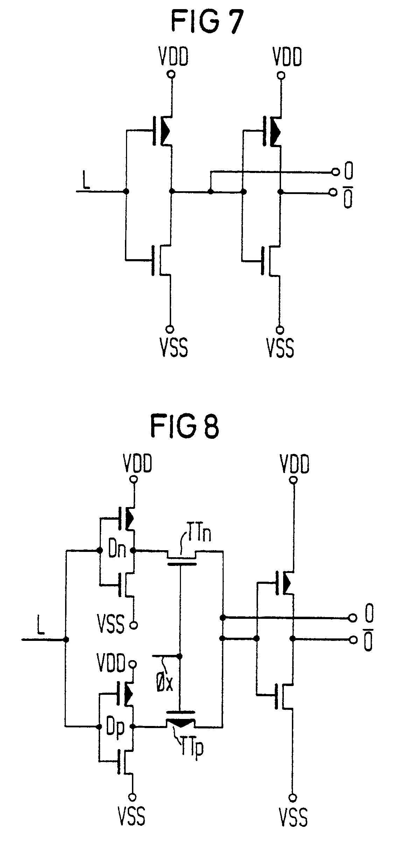

Die FIG 1 bis 6 zeigen beispielshaft verschiedene vorteilhafte Ausführungsformen der Erfindung; die FIG 7 und 8 zeigen mögliche Ausführungsformen von zugehörigen Diskriminatorschaltungen.

Die Ausführungsform nach FIG 1 zeigt die erfindungsgemäße Gatterschaltung mit m Eingängen $I1$ bis $Im$. Jeder Eingang $I1$ bis $Im$ ist über einen Transfertransistor $T1$ bis $Tm$ mit einer gemeinsamen Leitung L verbunden. Sämtliche Transfertransistoren $T1$ bis $Tm$ sind an ihrem Gate mit einem Transferpotential TPot verbunden.

Der Wert des Transferpotentials TPot liegt zwischen dem Wert eines ersten Versorgungspotentials VDD und einem Wert, der gleich ist den halben Potentialdifferenz zwischen dem ersten Versorgungspotential VDD und einem zweiten Versorgungspotential VSS. Die gemeinsame Leitung L ist unter Ausnützung der ihr eigenen parasitären Kapazitäten üben eine Vorladeeinrichtung PC auf das erste Potential VDD vorladbar. Die gemeinsame Leitung L ist außerdem mit einer Diskriminatorschaltung D verbunden. Diese dient den Detektierung des elektrischen Zustandes den gemeinsamen Leitung L. Den Ausgang der Diskriminatorschaltung D bildet den Ausgang O den gesamten Gatterschaltung.

In der Ausführungsform nach FIG 1 enthält die Vorladeeinrichtung PC eine Flip-Flop-Schaltung FF, vorzugsweise eine RS-Flip-Flop-Schaltung. Denen Ausgang Q ist schaltbar (Transistor T) mit der gemeinsamen Leitung L verbunden. Mittels eines Taktsignales $\emptyset$, das am Gate des Transistors T anliegt, ist somit das Vorladen den gemeinsamen Leitung L auf das erste Versorgungspotential VDD steuerbar.

Die Arbeitsweise der erfindungsgemäßen Gatterschaltung wird im folgenden kurz erläutert, wobei sogenannte "positive Logik" (log. I entspricht "high") angenommen wird. Anhand dieser Angaben ist der Fachmann in der Lage, auch die sogenannte "negative Logik" (log. I entspricht "low") auf die erfindungsgemäße Gatterschaltung anzuwenden. Zunächst wird in einen Vorladephase die gemeinsame Leitung L auf das erste Versorgungspotential (in der Ausführungsform nach FIG 1: VDD) vorgeladen. Dazu wird der Ausgang Q des Flip-Flops FF gesetzt. Das Taktsignal $\emptyset$ schaltet anschließend, noch in der Vorladephase, den Transistor T leitend, wodurch das Vorladen selbst durchgeführt wird. Anschließend sperrt das Taktsignal $\emptyset$ den Transistor T wieder.

In der Ausführungsform nach FIG 2 enthält die Vorladeeinrichtung einen Schalttransistor, der sourcemäßig direkt mit dem ersten Versorgungspotential VDD verbunden ist. Dessen Gate ist wiederum mit dem Taktsignal $\emptyset$ verbunden. Diese Ausführungsform funktioniert im Prinzip genauso wie die oben beschriebene Ausführungsform mit Flip-Flop FF und Transistor T.

Bekanntlich weist jede elektrische Leitung unabhängig davon, ob sie in eine integrierte Schaltung integriert ist oder nicht, eine gewisse Eigenkapazität auf, die durch Designmaßnahmen (z.B. Länge, Breite, Dicke) beeinflußbar ist. Diese Eigenkapazität ermöglicht nach der Vorladephase, daß die gemeinsame Leitung L auf das erste Versorgungspotential VDD für einen bestimmten Mindestzeitraum t (t ist abhängig von technologiebedingt nicht vermeidbaren Leckströmen) vorgeladen bleibt. In Weiterbildung der Erfindung ist es gemäß FIG 2 möglich, diese kapazitiv bedingte Eigenschaft den gemeinsamen Leitung L durch explizite Ankopplung einer Kapazität CL an die gemeinsame Leitung L zu unterstützen. Die freie Elektrode der Kapazität CL ist dabei entweder fest oder schaltbar mit dem zweiten Versorgungspotential VSS verbunden.

Liegt nun an sämtlichen Eingängen $I1$ bis $Im$ eine log. I an (= erstes Versorgungspotential VDD), so sperren sämtliche Transfertransistoren $T1$ bis $Tm$, da sowohl an Source wie auch an Drain eines jeden Transfertransistors $T1$ bis $Tm$ ein Potential anliegt, das größer ist als das am Gate anliegende Transferpotential TPot (Annahme: die Transfertransistoren seien vom n-Kanal-Leitungstyp).

Die gemeinsame Leitung L bleibt somit auf den Wert des ersten Versorgungspotentials VDD vorgeladen. Die angeschlossene Diskriminatorschaltung D erkennt dies und gibt am Ausgang O ein entsprechendes Signal ab, beispielsweise vom Wert des zweiten Versorgungspotentials VSS. Liegt jedoch an mindestens einem der Eingänge I1 bis Im (beispielsweise am Eingang Ii) eine log. O an (= zweites Versorgungspotential VSS), so leitet der diesem Eingang zugehörige Transfertransistor (im Beispiel: Ti) Damit kann über diesen Transfertransistor Ti Ladung von der gemeinsamen Leitung L auf den betroffenen Eingang Ii abfließen. Die gemeinsame Leitung L wird somit potentialmäßig in Richtung log. O gezogen. Dies geschieht solange, bis diejenigen Transfertransistoren T1 bis Tm zu leiten beginnen, deren zugehörige Eingänge I1 bis Im auf log. I liegen. Es stellt sich dadurch ein Gleichgewicht ein bei etwa TPot - Vth (Vth: Schwellspannung der Transfertransistoren T1 bis Tm). Die Diskriminatorschaltung D erkennt dies und setzt den Ausgang O entsprechend auf das erste Versorgungspotential VDD. Bei dem bislang geschilderten Beispiel arbeitet die gesamte Gatterschaltung als NAND-Gattern.

Es ist vorteilhaft, wenn die Diskriminatorschaltung D eine CMOS-Inverterschaltung enthält, die zwischen den beiden Versorgungspotentialen VDD und VSS angeordnet ist und die so dimensioniert ist, daß ihr Umschaltpunkt zwischen dem Wert des Transferpotentials TPot und dem des ersten Versorgungspotentials VDD (Betrieb als AND- bzw. NAND-Gatter) bzw. dem des ersten Versorgungspotentials VSS (Betrieb als OR- bzw. NOR-Gatter; wird noch beschrieben) liegt. Diese Dimensionierung kann in einer vorteilhaften Ausführungsform dadurch erreicht sein, daß bei angenommener gleicher Kanallänge der Transistoren der CMOS-Inverter-Schaltung derjenige diesen Transistoren, der sourcemäßig mit dem ersten Versorgungspotential VDD (bzw. VSS im Falle des Betriebes als OR-/NOR-Gatter) verbunden ist, eine Kanalweite aufweist, die 10 bis 20 mal so groß ist wie die Kanallweite des anderen Transistors, der sourcemäßig mit dem zweiten Versorgungspotential VSS (bzw. VDD) verbunden ist.

In den speziellen Ausführungsform nach FIG 7 ist der CMOS-Inverterschaltung der eigentlichen Diskriminatorschaltung D eine weitere Inverterschaltung nachgeschaltet mit einem zum Ausgang O komplementären Ausgang $\overline{O}$. Mit dieser Ausführungsform ist es möglich, die erfindungsgemäße Gatterschaltung sowohl als AND- wie auch als NAND-Schaltung zu betreiben und auch, wie nachstehend noch beschrieben, als OR- oder NOR-Schaltung.

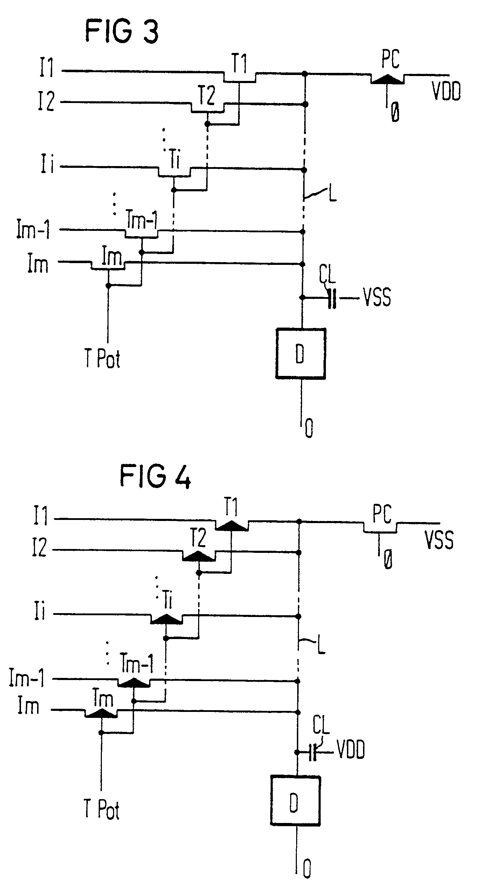

Der Schalttransistor der Vorladeeinrichtung PC nach FIG 2 ist vorteilhafterweise vom selben Leitungstyp (n-Kanal) wie die Transfertransistoren T1 bis Tm. In der ebenfalls vorteilhaften Ausführungsform nach FIG 3 ist er jedoch vom entgegengesetzten Leitungstyp (p-Kanal). Dies ist entsprechend beim Signalverlauf des Taktsignales $\emptyset$ zu berücksichtigen.

Während die bislang beschriebenen Ausführungsformen eine Ausgestaltung als AND- bzw. NAND-Gatter betreffen (positive Logik angenommen), so stellt die Ausführungsform nach FIG 4 eine Ausgestaltung als OR- bzw. NOR-Gatter dar: Unter der Annahme, daß das (bislang als zweites Versorgungspotential bezeichnete) Versorgungspotential VSS negativer ist als das (bislang als erstes Versorgungspotential bezeichnete) Versorgungspotential VDD, wird jetzt angenommen, daß für die FIG 4 als erstes Versorgungspotential das Versorgungspotential VSS verwendet ist und als zweites Versorgungspotential das Versorgungspotential VDD. Auch die Transfertransistoren T1 bis Tm weisen einen zu den bisherigen Ausführungsformen (n-Kanal) entgegengesetzten Leitungstyp auf (p-Kanal). Entsprechend liegt auch der Wert des Transferpotentials TPot zwischen dem Wert des ersten Versorgungspotentials VSS und einem Wert, den gleich ist der halben Potentialdifferenz zwischen dem ersten Versorgungspotential VSS und dem zweiten Versorgungspotential VDD. Außerdem wind die gemeinsame Leitung L auf das erste Versorgungspotential VSS vorgeladen. Eine nähere Erläuterung zur Arbeitsweise ist anhand dieser Angaben und der zuvor gegebenen Angaben über die Arbeitsweise der Ausgestaltung nach den FIG 1 bis 3 für den Fachmann entbehrlich.

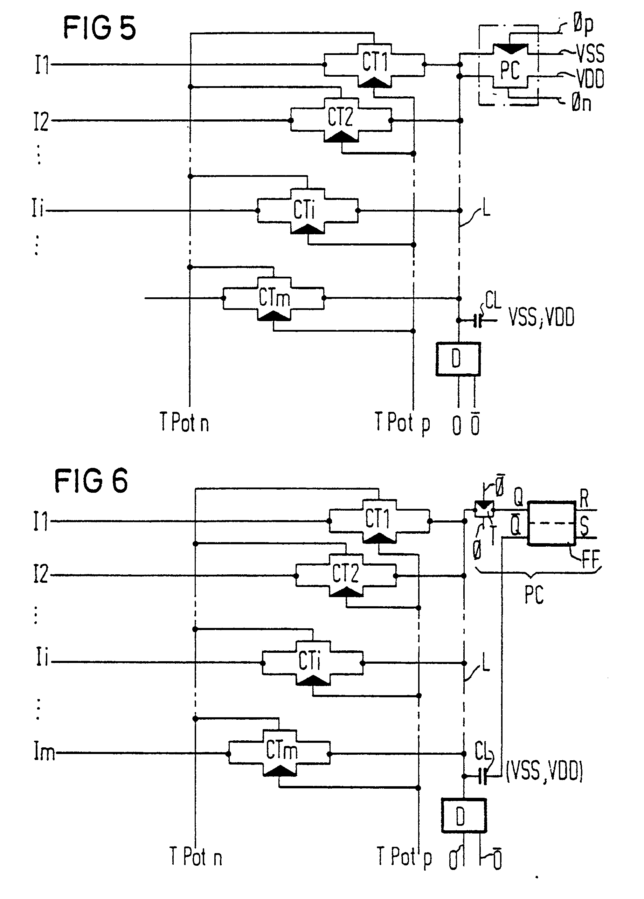

Besonders vorteilhafte Ausführungsformen zeigen die FIG 5 und 6: Sie sind in Abhängigkeit von ihrer Betriebsweise sowohl als AND-, als NAND-, als OR- und als NOR-Schaltung betreibbar. Dabei ist jeder Transfertransistor T1 bis Tm ersetzt durch ein Paar (CT1 bis CTm) zueinander paralleler Transistoren vom zueinander entgegengesetzten Leitungstyp. Die Gates den Transistoren vom einen Leitungstyp sind dabei mit einem ersten Transferpotential TPotn verbunden und die Gates der Transfertransistoren vom anderen Leitungstyp sind mit einem zweiten Transferpotential TPotp verbunden. Die beiden Transferpotentiale TPotn, TPotp sind entweder unabhängig voneinander anlegbar oder unabhängig, aber nicht gleichzeitig miteinander. Letztere Möglichkeit ergibt eine höhere Funkttionssicherheit.

Entsprechend weist auch die Vorladeeinrichtung PC nach FIG 5 zwei parallele Transistoren entweder vom gleichen (nicht dargestellt) oden vom zueinander entgegengesetzten Leitungstyp auf. Den Transistor vom einen Leitungstyp ist mit dem Versorgungspotential VSS verbunden. Der Transistor vom anderen Leitungstyp ist mit dem Versorgungspotential VDD verbunden. Das Gate des Transistors vom einen Leitungstyp ist mit einem ersten Taktsignal $\emptyset\text{p}$ verbunden. Das Gate des Transistors vom anderen Leitungstyp ist mit einem zweiten Taktsignal $\emptyset\text{n}$ verbunden.

Der Wert des ersten Transferpotentials TPotn liegt zwischen dem Wert des Versorgungspotentials VDD und einem Wert, der gleich ist der halben Potentialdifferenz zwischen dem Versorgungspotential VDD und dem Versorgungspotential VSS. Ebenso liegt der Wert des zweiten Transferpotentials TPotp zwischen dem Wert des Versorgungspotentials VSS und einem Wert, der gleich ist der halben Potentialdiffenenz zwischen dem Versorgungspotential VSS und dem Versorgungspotential VDD.

Soll die Schaltung als AND-/NAND-Gatter betrieben werden, so sind das erste Transferpotential TPotn und das zweite Taktsignal $\emptyset$n anzulegen. Soll die Schaltung jedoch als OR-/NOR-Gatter betrieben werden, so sind das zweite Transferpotential TPotp und das erste Taktsignal $\emptyset$p anzulegen. Eine ausführlichere Erläuterung erübrigt sich aufgrund der Ausführungen zu den FIG 1 und 4.

Die spezielle Ausführungsform der Diskriminatorschaltung D nach FIG 8 ermöglicht einen wahlweisen Betrieb der erfindungsgemäßen Gatterschaltung als AND-,NAND-,OR- und als NOR-Gatter. Die Diskriminatorschaltung D nach FIG 8 enthält einen für den Betrieb als NAND-/AND-Gatter vorgesehenen CMOS-Inverter Dn mit geeigneter unsymmetrischer Dimensionierung (wie vorstehend beschrieben). Sein Ausgang ist über einen Transfertransistor TTn mit dem Ausgang O verbunden und über den aus FIG 7 bekannten weiteren Inverter mit dem Ausgang $\overline{O}$. Das Gate des Transfertransistors TTn ist mit einem Betriebsartauswahlsignal $\emptyset$x verbunden. Die Diskriminatorschaltung D nach FIG 8 enthält des weiteren einen für den Betrieb als NOR-/OR-Gatter vorgesehen CMOS-Inverter Dp mit geeigneter unsymmetrischer Dimensionierung (wie bereits beschrieben). Sein Ausgang ist über einen weiteren Transfertransistor TTp ebenfalls mit dem Ausgang O verbunden und über den aus FIG 7 bekannten weiteren Inverter mit dem Ausgang $\overline{O}$.

Legt man nun im Betrieb das Betriebsartauswahlsignal $\emptyset$x auf das Versorgungspotential VDD, so sind in der Diskriminatorschaltung D der Transfertransistor TTn leitend und der weitere Transfertransistor TTp gesperrt. Die Gatterschaltung arbeitet somit als AND-/NAND-Schaltung. Legt man hingegen das Betriebsartauswahlsignal $\emptyset$x auf das Versorgungspotential VSS, so sind in der Diskriminatorschaltung der Transfertransistor TTn gesperrt und der weitere Transfertransistor TTp leitend. Die Gatterschaltung arbeitet somit als OR-/NOR-Schaltung.

Die Ausführungsform nach FIG 6 unterscheidet sich von der nach FIG 5 durch die Vorladeschaltung PC: Die Vorladeschaltung PC gleicht im wesentlichen derjenigen nach FIG 1. Sie enthält jedoch entweder einen Transistor (wie bei FIG 1) oder parallelgeschaltete Transistoren T vom einander entgegengesetzten Leitungstyp mit entsprechend komplementären Taktsignalen $\emptyset$, $\overline{\emptyset}$. Die Verwendung eines Flip-Flops FF ermöglicht das für den wahlweisen Betrieb als AND-/NAND- bzw. als OR-/NOR-Gatter notwendige wahlweise Vorladen der gemeinsamen Leitung L auf die Versorgungspotentiale VDD und VSS. Durch die Verwendung von zwei Transistoren T mit einander entgegengesetztem Leitungstyp wird ein (sonst je nach Vorladepotential üblicher) Spannungsabfall in Höhe der Schwellspannung eines Transistors T vermieden (läßt sich ansonsten nur vermeiden, wenn das Taktsignal $\emptyset$ (bzw. $\overline{\emptyset}$) einen gegenüber den Versorgungspotentialen überhöhten (bei n-Kanal-Technik) bzw. erniedrigten (bei p-Kanal-Technik) aktiven Pegel aufweist).

Ein weiterer Vorteil der Vorladung nach FIG 6 besteht darin, daß der bei einem Flip-Flop üblicherweise vorhandene Komplementärausgang $\overline{Q}$ mit der Kapazität CL verbunden werden kann. Dadurch ist die Kapazität CL unabhängig von der Betriebsart der Gatterschaltung stets (mindestens während der Vorladephase) mit beiden Versorgungspotentialen VDD und VSS verbunden (die gemeinsame Leitung L ist ja auf eines der beiden Versorgungspotentiale vorgeladen).

Weitere Untersuchungen hinsichtlich Schaltungen nach den FIG 1 bis 3 haben gezeigt, daß es außerdem vorteilhaft ist, wenn der Wert des Transferpotentials TPot zwischen dem Wert des ersten Versorgungspotentials VDD und einem Wert liegt, der gleich ist dem Wert des zweiten Versorgungspotentials VSS zuzüglich der Schwellspannung Vth der Transfertransistoren T1 bis Tm. Entsprechend hat es sich hinsichtlich FIG 4 gezeigt, daß es vorteilhaft ist, wenn der Wert des Transferpotentials TPot zwischen dem Wert des ersten Versorgungspotentials VSS und einem Wert liegt, der gleich ist dem Wert des zweiten Versorgungspotentials VDD abzüglich der Schwellspannung Vth der Transfertransistoren T1 bis Tm. Entsprechendes gilt auch für die Ausführungsformen nach den FIG 5 und 6.

Die Erfindung ist besonders vorteilhaft anwendbar bei integrierten Halbleiterspeichern mit eingebauter Paralleltesteinrichtung.

**Patentansprüche**

1. Gatterschaltung mit MOS-Transistoren und m Eingängen (I1 bis Im), von denen jeder über einen Transfertransistor (T1 bis Tm) mit einer gemeinsamen Leitung (L) verbunden ist, **gekennzeichnet durch** folgende Merkmale:

- die Gates der Transfertransistoren (T1 bis Tm) sind mit einem Transferpotential (TPot) verbunden, dessen Wert zwischen dem Wert eines ersten Versorgungspotentials (VDD;VSS) und der halben Potentialdifferenz aus dem ersten Versorgungspotential (VDD;VSS) und einem zweiten Versorgungspotential (VSS;VDD) der Gatterschaltung liegt, derart, daß bei Anlegen des ersten Versorgungspotentials (VDD;VSS) an einen Eingang (I1,...,Im) der entsprechende Transfertransistor (T1,...,Tm) gesperrt ist,
– die gemeinsame Leitung (L) ist über eine durch wenigstens ein Taktsignal ($\emptyset$,$\emptyset$p,$\emptyset$n,;$\emptyset$,$\emptyset$) schaltbare Vorladeeinrichtung (PC) auf das erste Versorgungspotential (VDD;VSS) vorladbar,
– die gemeinsame Leitung (L) ist mit einer Diskriminatorschaltung (D) zur Detektierung ihres Ladungszustandes verbunden,
– der Ausgang der Diskriminatorschaltung (D) ist der Ausgang (O) der Gatterschaltung.

2. Gatterschaltung nach Anspruch 1, **dadurch gekennzeichnet**, daß die Vorladeeinrichtung (PC) ein Flip-Flop (FF) enthält, dessen Ausgang (Q) schaltbar (T) mit der gemeinsamen Leitung (L) verbunden ist.

3. Gatterschaltung nach Anspruch 1, **dadurch gekennzeichnet**, daß die Vorladeeinrichtung (PC) einen Schalttransistor enthält, der vom selben Leitungstyp ist wie der Leitungstyp der Transfertransistoren (T1 bis Tm).

4. Gatterschaltung nach Anspruch 1, **dadurch gekennzeichnet**, daß die Vorladeeinrichtung (PC) einen Schalttransistor enthält, der vom entgegengesetzten Leitungstyp ist wie der Leitungstyp der Transfertransistoren (T1 bis Tm).

5. Gatterschaltung nach mindestens einem der vorhergehenden Ansprüche, **dadurch gekennzeichnet**, daß die Vorladeeinrichtung (PC) ein wahlweises Aufladen der gemeinsamen Leitung (L) auf eines der Versorgungspotentiale (VDD,VSS) ermöglicht und daß jeder Transfertransistor (T1 bis Tm) ersetzt ist durch ein Paar (CT1 bis CTm) zueinander parallelgeschalteter Transistoren vom zueinander entgegengesetzten Leitungstyp, wobei die Gates der Transistoren vom einen Leitungstyp mit einem ersten Transferpotential (TPotn) verbunden sind und die Gates der Transfertransistoren vom anderen Leitungstyp mit einem zweiten Transferpotential (TPotp).

6. Gatterschaltung nach einem der vorhergehenden Ansprüche, **dadurch gekennzeichnet**, daß die gemeinsame Leitung (L) mit einer Kapazität (CL) verbunden ist, die ihrerseits wiederum fest oder schaltbar mit einem der beiden Versorgungspotentiale (VDD,VSS) verbunden ist.

7. Gatterschaltung nach einem der vorhergehenden Ansprüche, **dadurch gekennzeichnet**, daß die Diskriminatorschaltung (D) eine zwischen den beiden Versorgungspotentialen (VDD,VSS) angeordnete CMOS-Inverterschaltung enthält, die so dimensioniert ist, daß ihr Umschaltpunkt zwischen dem Wert des Transferpotentials (TPot;TPotn,TPotp) und dem des ersten Versorgungspotentials (VDD;VSS), verringert um die Transistoreinsatzspannung (Vth) der Transfertransistoren (T1 bis Tm;CT1 bis CTm), liegt.

8. Gatterschaltung nach Anspruch 7, **dadurch**

**gekennzeichnet**, daß bei angenommener gleicher Kanallänge der Transistoren der CMOS-Inverterschaltung derjenige dieser Transistoren, der sourcemäßig mit dem ersten Versorgungspotential (VSS;VDD) verbunden ist, eine Kanalweite aufweist, die 10 bis 20 mal so groß ist wie die Kanalweite des anderen Transistors, der sourcemäßig mit dem zweiten Versorgungspotential (VSS;VDD) verbunden ist.

9. Gatterschaltung nach Anspruch 7 oder 8, **dadurch gekennzeichnet**, daß der CMOS-Inverterschaltung eine weitere Inverterschaltung nachgeschaltet ist.

10. Gatterschaltung nach einem der vorhergehenden Ansprüche, **dadurch gekennzeichnet**, daß das Transferpotential (TPot;TPotn;TPotp) einen Wert aufweist zwischen dem Wert des zweiten Versorgungspotentials (VSS;VDD) zuzüglich (bei VSS mit VDD > VSS) bzw. abzüglich (bei VDD mit VDD > VSS) des Wertes der Schwellspannung (Vth) der Transfertransistoren (T1 bis Tm) und den Wert des ersten Versorgungspotentials (VDD; VSS).

**Claims**

1. Gate circuit with MOS transistors and m inputs (I1 to Im), each of which is connected via a transfer transistor (T1 to Tm) to a common line (L), characterised by the following features:
– the gates of the transfer transistors (T1 to Tm) are connected to a transfer potential (TPot), whose level lies between the level of a first supply potential (VDD; VSS) and half of the potential difference between the first supply potential (VDD; VSS) and a second supply potential (VSS; VDD) to the gate circuit, such that when the first supply potential (VDD; VSS) is applied to an input (I1,...,Im) the associated transfer transistor (T1,...,Tm) is blocked,
– the common line (L) can be pre-charged to the first supply potential (VDD; VSS) via a pre-charging device (PC) which can be switched by at least one clock signal ($\emptyset$, $\emptyset$p, $\emptyset$n,;$\emptyset$$\emptyset$),
– the common line (L) is connected to a discriminator circuit (D) to detect its charge state,
– the output of the discriminator circuit (D) is the output (O) of the gate circuit.

2. Gate circuit according to Claim 1, characterised in that the pre-charging device (PC) contains a flip-flop (FF), whose output (Q) is connected in a switchable manner (T) to the common line (L).

3. Gate circuit according to Claim 1, characterised in that the pre-charging device (PC) contains a switching transistor, which is of the same conduction type as the conduction type of the transfer transistors (T1 to Tm).

4. Gate circuit according to Claim 1, characterised in that the pre-charging device (PC) contains a switching transistor, which is of the opposite conduction type to the conduction type of the transfer transistors (T1 to Tm).

5. Gate circuit according to at least one of the preceding claims, characterised in that the pre-charging device (PC) allows selective charging of the common line (L) to one of the supply potentials (VDD, VSS) and in that each transfer transistor (T1 to Tm) is replaced by a pair (CT1 to CTm) of transistors connected in parallel with one another but of opposite conduction types, the gates of the transistors of one conduction type being connected to a first transfer potential (TPotn) and the gates of the transfer transistors of the other conduction type being connected to a second transfer potential (TPotp).

6. Gate circuit according to one of the preceding claims, characterised in that the common line (L) is connected to a capacitor (CL), which for its part is in turn connected directly or in a switchable manner to one of the two supply potentials (VDD, VSS).

7. Gate circuit according to one of the preceding claims, characterised in that the discriminator circuit (D) contains a CMOS invertor circuit arranged between the two supply potentials (VDD, VSS), having dimensions such that its switching point lies between the level of the transfer potential (TPot; TPotn, TPotp) and that of the first supply potential (VDD; VSS), reduced by the transistor threshold voltage (Vth) of the transfer transistors (T1 to Tm ; CT1 to CTm).

8. Gate circuit according to Claim 7, characterised in that, assuming the channel lengths of the transistors in the CMOS-invertor circuit are equal, the one of these transistors whose source is connected to the first supply potential (VDD; VSS) has a channel width which is 10 to 20 times as great as the channel width of the other transistor, whose source is connected to the second supply potential (VSS; VDD).

9. Gate circuit according to Claim 7 or Claim 8, characterised in that a further invertor circuit is connected to the output of the CMOS invertor circuit.

10. Gate circuit according to one of the preceding claims, characterised in that the transfer potential (TPot; TPotn; TPotp) exhibits a level between the level of the second supply potential (VSS; VDD) plus (for VSS when VDD > VSS) or minus (for VDD when VDD > VSS) the level of the threshold voltage (Vth) of the transfer transistors (T1 to Tm) and the level of the first supply potential (VDD; VSS).

## Revendications

1. Circuit de porte comprenant un transistor MOS et m entrées (I1 à Im), dont chacune est raccordée à un conducteur commun (L) par l'intermédiaire d'un transistor de transfert (T1 à Tm), caractérisé par les particularités suivantes:
   – les grilles des transistors de transfert (T1 à Tm) sont raccordées à un potentiel de transfert (TPot), dont la valeur est comprise entre la valeur d'un premier potentiel d'alimentation (VDD;VSS) et la moitié de la différence entre le premier potentiel d'alimentation (VDD;VSS) et un second potentiel d'alimentation (VSS;VDD) du circuit de porte, de sorte que, lors de l'application du premier potentiel d'alimentation (VDD;VSS) à une entrée (I1;...;Im), le transistor de transfert correspondant (T1,...Tm) est bloqué,
   – le conducteur commun (L) peut être préchargé au premier potentiel d'alimentation (VDD;VSS) par l'intermédiaire d'un dispositif de précharge (PC) pouvant être commuté par au moins un signal de cadence ($\emptyset,\emptyset$p,$\emptyset$n;$\emptyset,\emptyset$),
   – le conducteur commun (L) est raccordé à un circuit discriminateur (D) servant à détecter son état de charge,
   – la sortie du circuit discriminateur (D) constitue la sortie (K) du circuit de porte.

2. Circuit de porte suivant la revendication 1, caractérisé par le fait que le dispositif de précharge (PC) comporte une bascule bistable (FF), dont la sortie (Q) est reliée, d'une manière commutable (T), au conducteur commun (L).

3. Circuit de porte suivant la revendication 1, caractérisé par le fait que le dispositif de précharge (PC) comporte un transistor de commutation, qui possède le même type de conduction que celui des transistors de transfert (T1 à Tm).

4. Circuit de porte suivant la revendication 1, caractérisé par le fait que le dispositif de précharge (PC) comporte un transistor de commutation qui possède le type de conduction opposé à celui des transistors de transfert (T1 à TM).

5. Circuit de porte suivant au moins l'une des revendications précédentes, caractérisé par le fait que le dispositif de précharge (PC) permet une charge, au choix, du conducteur commun (N) à l'un des potentiels d'alimentation (VDD, VSS), et que chaque transistor de transfert (T1 à Tm) est remplacé par un couple (CT1 à CTm) de transistors branchés en parallèle entre eux, possédant des types de conduction réciproquement opposés, les grilles des transistors possédant un type de conduction étant raccordées à un premier potentiel de transfert (TPotn), tandis que les grilles des transistors de transfert possédant l'autre type de conduction sont raccordées à un second potentiel de transfert (TPotp).

6. Circuit de porte suivant l'une des revendications précédentes, caractérisé par le fait que le conducteur commun (L) est raccordé à une capacité (CL), qui, pour sa part, est à nouveau raccordée de façon fixe ou commutable, à l'un des deux potentiels d'alimentation (VDD, VSS).

7. Circuit de porte suivant l'une des revendications précédentes, caractérisé par le fait que le circuit discriminateur (D) comporte un circuit inverseur CMOS, qui est disposé entre les deux potentiels d'alimentation (VDD, VSS) et est dimensionné de manière que son point de commutation soit situé entre la valeur du potentiel de transfert (TPot;Tpotn;Tpotp) et celui du premier potentiel d'alimentation (VDD;VSS), diminué de la tension (Vth) de déclenchement des transistors de transfert (T1 à Tm; CT1 à CTm).

8. Circuit de porte suivant la revendication 7, caractérisé par le fait que, pour une même longueur supposée des canaux des transistors du circuit inverseur CMOS, celui des transistors, dont la sortie est raccordée au premier potentiel d'alimentation (VDD;VSS), possède une largeur de canal qui est 10 à 20 fois supérieure à la largeur du canal de ce transistor, dont la source est raccordée au second potentiel d'alimentation (VSS;VDD).

9. Circuit de porte suivant la revendication 7 ou 8, caractérisé par le fait qu'un autre circuit inverseur est branché en aval du circuit inverseur CMOS.

10. Circuit de porte suivant l'une des revendications précédentes, caractérisé par le fait que le potentiel de transfert (TPot; TPotn; TPotp) possède une valeur comprise entre la valeur du second potentiel d'alimentation (VSS;VDD) accrue (dans le cas de VSS avec VDD > VSS) ou réduite (dans le cas de VDD avec VDD > VSS) de la valeur de la tension de seuil (Vth) des transistors de transfert (T1 à Tm) et la valeur du premier potentiel d'alimentation (VDD;VSS).

# FIG 1

# FIG 2

## FIG 3

## FIG 4

## FIG 5

## FIG 6

# FIG 7

# FIG 8